# EUROPÄISCHE PATENTSCHRIFT

(11) **EP 3 526 160 B1**
(45) Veröffentlichungstag und Bekanntmachung des Hinweises auf die Patenterteilung: **11.08.2021**
(21) Anmeldenummer: 17787886.5
(22) Anmeldetag: 04.10.2017
(51) Int. Cl.: B81C 1/00, H01G 4/00, G01R 33/00, G01R 33/07, G01R 33/09

(54) **VERFAHREN ZUR HERSTELLUNG MINDESTENS EINES DREIDIMENSIONALEN BAUELEMENTES ZUR UNI-, BI-, TRI - ODER MULTIDIREKTIONALEN MESSUNG UND/ODER GENERIERUNG VON VEKTORFELDERN UND DREIDIMENSIONALES BAUELEMENT ZUR UNI-, BI,- TRI- ODER MULTIDIREKTIONALEN MESSUNG UND/ODER GENERIERUNG VON VEKTORFELDERN**
METHOD FOR PRODUCING AT LEAST ONE THREE-DIMENSIONAL COMPONENT FOR THE UNI-, BI-, TRI- OR MULTI-DIRECTIONAL MEASUREMENT AND/OR GENERATION OF VECTOR FIELDS AND THREE-DIMENSIONAL COMPONENT FOR THE UNI-, BI-, TRI- OR MULTI-DIRECTIONAL MEASUREMENT AND/OR GENERATION OF VECTOR FIELDS
PROCÉDÉ DE FABRICATION D'AU MOINS UN COMPOSANT TRIDIMENSIONNEL POUR UNE MESURE UNIDIRECTIONNELLE, BIDIRECTIONNELLE, TRIDIRECTIONNELLE OU MULTIDIRECTIONNELLE ET/OU POUR UNE GÉNÉRATION DE CHAMPS VECTORIELS ET COMPOSANT TRIDIMENSIONNEL POUR UNE MESURE UNIDIRECTIONNELLE, BIDIRECTIONNELLE, TRIDIRECTIONNELLE, OU MULTIDIRECTIONNELLE ET/OU GÉNÉRATION DE CHANTS VECTORIELS.

(30) Priorität: 13.10.2016 DE 102016220024
(43) Veröffentlichungstag der Anmeldung: 21.08.2019
(73) Patentinhaber: Leibniz-Institut für Festkörper- und Werkstoffforschung Dresden e.V., 01069 Dresden (DE)
(72) Erfinder: KARNAUSHENKO, Daniil, 01187 Dresden (DE); KARNAUSHENKO, Dimitriy, 01187 Dresden (DE); SCHMIDT, Oliver G., 01219 Dresden (DE)
(74) Vertreter: Rauschenbach, Marion
(86) Internationale Anmeldenummer: PCT/EP2017/075200
(87) Internationale Veröffentlichungsnummer: WO 2018/069112

(56) Entgegenhaltungen:
- DE-A1- 10 159 415
- DE-A1-102011 005 452
- DE-A1-102012 221 932
- DE-A1-102015 219 696
- DE-B3-102014 223 873
- US-A1- 2014 103 486

## Beschreibung

Die Erfindung bezieht sich auf die Gebiete der Elektrotechnik, der Mikroelektronik, der Werkstofftechnik und des Maschinenbaus und betrifft ein Verfahren zur Herstellung eines dreidimensionalen Bauelementes zur bi-, tri- oder multidirektionalen Messung und/oder Generierung von Vektorfeldern, die beispielsweise als Sensor, Kondensator, Widerstand oder Quelle mindestens die Richtung einer Eigenschaft in einem Vektorfeld misst, wie beispielsweise magnetische oder elektromagnetische Größen, Druck- und Zugbelastung, mechanische Spannung, Temperatur oder Feldgradienten, oder ein Vektorfeld generiert.

Bauelemente mit unterschiedlichen elektrischen, elektronischen, thermischen, mechanischen und/oder magnetischen Eigenschaften, die beispielsweise durch die Richtung, die Größe und/oder den Gradienten von magnetischen, elektromagnetischen, mechanischen oder Temperaturgrößen beeinflusst werden, sind in nahezu allen elektrischen und elektronischen Geräten zu finden. Derartige Bauelemente können Kondensatoren, Sensoren, Aktoren, Energiespeicherbauelemente und dergleichen sein.

Da derartige Bauelemente insbesondere in elektronischen Schaltkreisen in elektronischen oder elektrischen Geräten eingebaut werden, ist eine möglichst einfache und günstige Herstellung dieser Bauelemente sowie eine geringe Baufläche innerhalb der Geräte von großer Bedeutung, damit die Funktionsdichte solcher Schaltkreise weiter erhöht werden kann.

Um eine möglichst einfache und kostengünstige Herstellung bei geringer Baufläche für Bauelemente in elektronischen Schaltkreisen zu realisieren, können die Bauelemente beispielsweise mechanisch selbst-zusammenbauend (self-assembled) in 3D-Geometrien, zum Beispiel aufgerollt, werden.

Bei der Roll-up-Technologie werden Schichten auf ein Substrat aufgebracht, die sich nachfolgend beim kontrollierten Ablösen vom Substrat von selbst aufrollen. Der Mechanismus des selbstständigen Aufrollens wird beispielsweise durch Aufbringen der Schichten in einem Verspannungszustand und nachfolgendes mechanisches Entspannen, beispielsweise durch Ablösen der Schichten vom Substrat, ausgelöst. Das selbstständige Aufrollen von verspannten Dünnschichtkondensatoren, wenn diese von einem Substrat abgelöst werden, ist gemäß EP 2 023 357 B1 bekannt.

Selbstaufrollende GMI-Sensoren werden gemäß D. Karnaushenko et al.: Advanced Materials 27, S. 6582-6589, 2015 auf Chips integriert.

Aufgerollte helikale Antennen zur Anwendung in der Implantologie ist gemäß D. Karnaushenko et al.: Asia Materials 7, e188, 2015 bekannt.

Statt des Aufrollens in der Roll-up Technologie in eine Zylinderform sind weitere Formen durch selbstständiges Zusammenbauen (self-assembled) realisierbar.

Ebenfalls sind die Herstellung von gerollten Widerständen (F. Cavallo, et al: Applied Physics Letters, Bd. 93, Nr. 14, S. 143113-143113-3, Okt. 2008) oder die Herstellung von aufgewickelten thermoelektrischen Bauelementen (DE 10 2008 040 472 A1) bekannt.

Gemäß S. Mendach, et al: Physica E: Low-dimensional Systems and Nanostructures, Bd. 23, Nr. 3-4, S. 274-279, Juli 2004 ist die Herstellung von gekrümmten zweidimensionalen elektronischen Systemen in InGaAs/GaAs-Mikroröhren bekannt.

Verschiedene Untersuchungen sind weiterhin für den Einsatz von starren Hallsensoren in rotierenden (Bleuler et al., Automatica Vol. 30 No. 5, S. 871-876) und nicht rotierenden (Yi et al., Proceedings of the 34th Conference on Decision and Control, New Orleans 1995) Anwendungen bekannt.

Zur flussbasierten Regelung von Asynchronmotoren wurde auch der Einsatz von Mikro-Elektromechanischen Systemen (MEMS) vorgeschlagen (Nerguizian et al., European Micro and Nano Systems, EMN 2004, Paris ISBN: 2-84813-037-7).

Ein dreiachsiger Hall-Sensor wurde von Wouters et al: Sensors and Actuators A 237 (2016) 62-71 vorgeschlagen, mit dem alle drei Komponenten eines Magnetfeldes gleichzeitig mit hoher Präzision gemessen werden können. Dazu sind drei uniaxiale Hallsensoren zu dem dreiachsigen Hall-Sensor zu einem Würfel zusammengefügt worden. Der Zusammenbau der einzelnen Sensoren erfolgt so, dass die Messrichtung je eines Sensors je einer Komponente des Magnetfeldes entspricht und damit die Messung der orthogonal angeordneten drei Komponenten des Magnetfeldes in allen drei Raumrichtungen gleichzeitig durchgeführt werden kann.

Ebenso sind 3D-Hall-Sensoren bekannt, bei denen laterale und vertikale Hall-Elemente zusammen auf einem Chip platziert werden, so dass dann der dreidimensionale Vektor der magnetischen Flussdichte gemessen werden kann. Hierzu werden mehrere Hall-Elemente pro Richtung verwendet und punktsymmetrisch um einen Mittelpunkt angeordnet. So kann der 3D-Hall-Sensor quasi punktförmig messen (Wikipedia, Stichwort Hall-Sensor).

Weiter ist aus der US 8,786,378 B2 ein dreidimensionaler Magnetfeldsensor und ein Verfahren zu seiner Herstellung bekannt, bei dem auf einem planaren Substrat drei MR-Elemente angeordnet sind, wobei ein MR-Element die Magnetisierung in X-Richtung aufweist, ein MR-Element die Magnetisierung in Y-Richtung aufweist und MR-Element die Magnetisierung in Z-Richtung aufweist,

Weiterhin sind aus der DE 10 2012 221 932 A1 aufgerollte, dreidimensionale Feldeffekttransistoren und ihre Verwendung in der Elektronik, Sensorik und Mikrofluidik bekannt. Die Feldeffekttransistoren bestehen aus mindestens zwei gemeinsam aufgerollten Dünnschichten aus einem Halbleitermaterial und aus einem elektrisch leitenden Gate-Material, die durch eine oder mehrere Barriereschichten voneinander getrennt angeordnet sind.

Gemäß der DE 10 2014 223 873 B3 ist ein Verfahren zur Herstellung eines aufgerollten elektrischen oder elektronischen Bauelements bekannt, bei dem auf ein Substrat mit einer Opferschicht mindestens zwei abwechselnd ganz oder teilweise übereinander angeordnete Funktions- und Isolationsschichten aufgebracht werden, wobei mindestens die Funktions- oder Isolationsschicht, die direkt auf der Opferschicht angeordnet ist, mindestens an den beiden Seiten, die im Wesentlichen parallel zur Rollrichtung angeordnet sind, eine Perforierung aufweisen.

Aus der DE 10 2015 219 696 A1 ist ein Verfahren zur Herstellung eines kompakten Mikro- oder Nano-Kondensators bekannt, bei dem auf einem Substrat ein Schichtstapel aus mindestens zwei Schichten aus einem elektrisch isolierenden Material angeordnet sind, und die mindestens zwei Funktionsschichten mit den Schichten aus einem zweidimensionalen Material quer zur Aufrollrichtung auf je einer Seite abwechselnd über die Breite des Schichtstapels hinausreichend angeordnet werden, und nachfolgend der Schichtstapel aufgerollt und die hinausreichenden Schichten stoffschlüssig miteinander verbunden werden.

Weiter ist aus der DE 10 2011 005 452 A1 magnetoelektronisches Bauelement und ein Verfahren zu seiner Herstellung bekannt. Dazu werden auf eine isolierende Dünnschicht mindestens ein längliches Element aus einem magnetischen Material und elektrische Kontakte aufgebracht und darauf eine weitere isolierende Dünnschicht. Die Schichten werden mit einem Verspannungsgradienten aufgebracht, so dass nach dem Lösen der Verspannung der Schichtstapel aufrollt.

Und ebenfalls ist aus der US 2014/0103486 A1 eine aufgerollte Induktionsspule bekannt, die aus elektrisch leitenden Schichten und einer zug-entlasteten Schicht besteht.

Gemäß der DE 101 59 415 A1 und der EP 2 023 357 B1 sind ein Verfahren zur Herstellung von Mikrobauelementen bekannt, bei dem ein Abschnitt einer Hilfsschicht von einem Substrat abgelöst wird und dabei eine zuvor auf die Hilfsschicht aufgebrachte Leiterbahn eingerollt wird.

Ein Nachteil der Lösungen des Standes der Technik ist, dass die bekannten Bauelemente zur Messung und/oder Generierung von Vektorfeldern immer nur einzelnen Richtungen ein Vektorfeld messen oder generieren können und so eine hohe Anzahl an Bauelementen bei hohem Raumbedarf erforderlich ist, oder in den wenigen bekannten Fällen einer 3D-Bauweise solcher Bauelemente Messung und/oder Generierung von Vektorfeldern diese nur kompliziert mit Spezialtechnologien herstellbar sind und auch dann die Mess- und Generierungsrichtungen in einem Vektorfeld nur auf die jeweilige Richtung der einzelnen Sensoren in dem zusammengebauten 3D-Bauelement begrenzt sind.

Aufgabe der vorliegenden Lösung ist es, ein einfaches und kostengünstiges Verfahrens zur Herstellung eines dreidimensionalen Bauelementes zur bi-, tri- oder multidirektionalen Messung und/oder Generierung von Vektorfeldern anzugeben, welches zur Messung und/oder Generierung von Vektorfeldern in mehreren Richtungen und/oder gleichzeitig bei geringem Raumbedarf in der Lage ist.

Die Aufgabe wird mit den in den Patentansprüchen enthaltenen Merkmalen gelöst, wobei die Erfindung auch Kombinationen der einzelnen abhängigen Patentansprüche im Sinne einer UND-Verknüpfung mit einschließt, solange sie sich nicht gegenseitig ausschließen.

Bei dem erfindungsgemäßen Verfahren zur Herstellung mindestens eines dreidimensionalen Bauelementes zur bi-, tri oder multidirektionalen Messung und/oder Generierung von Vektorfeldern, werden
- auf einem Substrat
- mindestens eine Opfer- und/oder Adhäsionsschicht und,
- darauf mindestens eine Schicht aus einem Trägermaterial für einen Träger in einer helikalen, röhrenförmigen, elliptischen, hyperbolischen, toroidalen, wellenförmigen und/oder polygonalen Form aufgebracht,
- und darauf ganz oder teilweise mindestens eine oder mehrere Schichten aus Materialsystemen für mindestens zwei Bauteile zur Messung und/oder Generierung von Vektorfeldern in mindestens zwei unterschiedlichen Richtungen, sowie Schichten aus elektrisch leitfähigem Material für elektrische Kontaktierungen der Bauteile aufgebracht,
- wobei die einzelnen Schichten ganz oder teilweise vollflächig aufgebracht werden, und
- nachfolgend die Opfer- und/oder Adhäsionsschicht mindestens teilweise von dem Substrat entfernt oder zur Ablösung von dem Substrat modifiziert werden, und
- wobei die Anordnung der einen oder mehreren Schichten aus Materialsystemen für die Bauteile auf der Trägerschicht an der Position auf der Trägerschicht dahingehend gezielt ausgewählt wird, dass nach der Herstellung des dreidimensionalen Bauelementes das jeweilige Bauteil sich an der dreidimensional gewünschten Position befindet, und
- nachfolgend die Opfer- und/oder Adhäsionsschicht mindestens teilweise von dem Substrat entfernt oder zur Ablösung von dem Substrat modifiziert werden, und durch das Entfernen oder Auslösen der Modifizierung der Opfer- und/oder Adhäsionsschicht die Verformung aller aufgebrachten Schichten in einem einzigen Herstellungsprozess durchführt wird, und
- weitere Verfahrensschritte durchgeführt werden können.

Vorteilhafterweise werden die Schichten mittels lithografischer- oder/und Druckverfahren aufgebracht.

Es ist auch vorteilhaft, wenn mindestens mehrere Schichten aus Materialsystemen für mindestens zwei oder mehrere Bauteile zur Messung und/oder Generierung von Vektorfeldern in mindestens zwei oder drei oder mehr Richtungen, sowie Schichten aus elektrisch leitfähigem Material für elektrische Kontaktierungen der Bauteile aufgebracht werden.

Ebenfalls vorteilhafterweise wird ein Substrat aus halbleitenden Materialien, Glas, Metall, Metallverbindungen, organischen Metallkomplexen, Si, Si-Wafern, Polymeren oder flexible und/oder dehnbare Materialien eingesetzt.

Weiterhin vorteilhafterweise wird eine Opferschicht und/oder Adhäsionsschicht aus Metall, Metallverbindungen, organische Metallkomplexe, Keramik, halbleitende Materialien und/oder Polymer eingesetzt.

Und auch vorteilhafterweise wird ein Trägermaterial aus Metall, Metallverbindungen, organische Metallkomplexe, Keramik, halbleitende Materialien und/oder Polymer eingesetzt, wobei vorteilhafterweise eine Schicht aus einer quellbaren Schicht bestehen kann, die ganz oder teilweise auf der Opfer- und/oder Adhäsionsschicht positioniert sein kann, und wobei aus der oder den Schichten aus dem Trägermaterial ein dreidimensionaler Träger in einer helikalen, röhrenförmigen (zylindrische), elliptischen, hyperbolischen, torodialen, wellenförmigen und/oder polygonalen Form hergestellt wird, der mit den weiteren darauf aufgebrachten Schichten das dreidimensionale Bauelement bildet.

Vorteilhaft ist es auch, wenn Schichten aus Materialsystemen für Kontaktierungen, Hall-, GMR-, TMR-, AMR-, MR-, MI-, GMI-Sensoren, Spinventile, magnetische Spulen, Antennen, optische Sensoren und/oder Quellen, mechanische Zug- und/oder Drucksensoren, thermische Sensoren, akustische Sensoren, Kondensatoren, Transistoren, Dioden und/oder Widerstände als Bauteile aufgebracht werden.

Mit dem erfindungsgemäßen Verfahren wird ein dreidimensionales Bauelement zur bi-, tri oder multidirektionalen Messung und/oder Generierung von Vektorfeldern hergestellt, bei welchem
- auf einem dreidimensionalen Träger aus mindestens einem Trägermaterial für einen Träger in einer helikalen, röhrenförmigen, elliptischen, hyperbolischen, toroidalen, wellenförmigen und/oder polygonalen Form,
- mindestens zwei Bauteile aus Materialsystemen vorhanden,
- welches in ihrer räumlichen Position auf, an und/oder in dem Träger mindestens ein Vektorfeld in mindestens zwei unterschiedlichen Richtungen misst und/oder generiert.

Als Trägermaterial können Metall, Metallverbindungen, organische Metallkomplexe, Keramik, halbleitende Materialien und/oder Polymer vorhanden sein.

Ebenfalls bildet der dreidimensionale Träger mit den weiteren darauf, -an und/oder - in befindlichen Bauteilen das dreidimensionale Bauelement.

Weiterhin sind als Kontaktierungen Leiterbahnen oder Schichten aus mindestens teilweise elektrisch leitfähigem Material, wie Metalle, leitfähige Polymere, Halbleiter oder Oxide vorhanden.

Ebenso können die Bauteile in einer anderen Position an, auf und/oder in dem Träger vorhanden sein, als in der Herstellungsposition.

Bei den erfindungsgemäß hergestellten dreidimensionalen Bauelementen können Kontaktierungen, Hall-, GMR-, TMR-, AMR-, MR-, MI-, GMI-Sensoren, Spin-ventile, magnetische Spulen, Antennen, optische Sensoren und/oder Quellen, mechanische Zug- und/oder Drucksensoren, thermische Sensoren, akustische Sensoren, Magneten, Kondensatoren, Transistoren, Dioden und/oder Widerstände als Bauteile vorhanden sein.

Vorteilhaft ist es, wenn mindestens drei Bauteile an, auf und/oder in dem Träger angeordnet sind, wobei die Mess- und/oder Generierungs-Richtungen der Bauteile unterschiedlich von 90° zueinander angeordnet sind.

Dabei kann das erfindungsgemäß hergestellte Bauelement Abmessungen im Milli-, Mikro- und/oder Nanometerbereich aufweisen.

Und auch vorteilhafterweise kann der Träger eine Breite von mindestens 0.1 mm und eine Länge von mindestens 0.1 mm Länge und eine Wanddicke von mindestens 1 µm aufweisen.

Mit der vorliegenden Erfindung wird es erstmals möglich, ein einfaches und kostengünstiges Verfahren zur Herstellung eines dreidimensionalen Bauelementes zur bi-, tri- oder multidirektionalen Messung und/oder Generierung in Vektorfeldern anzugeben, welches zur Messung und/oder Generierung von Vektorfeldern in mehreren Richtungen und/oder gleichzeitig bei geringem Raumbedarf in der Lage ist.

Erreicht wird dies durch das erfindungsgemäße Verfahren, bei dem auf einem Substrat mindestens eine Opfer- und/oder Adhäsionsschicht aufgebracht wird.

Als Substrat können vorteilhafterweise halbleitende Materialien, Glas, Metall, Metallverbindungen, organischen Metallkomplexe, Substrate aus Si, Siliciumdioxid, Si-Wafer, Polymere oder flexible und/oder dehnbare Materialien eingesetzt werden.

Die Opfer- und/oder Adhäsionsschicht können aus Metall, Metallverbindungen, organische Metallkomplexen, Keramik, halbleitenden Materialien und/oder Polymeren bestehen.
Die Opfer- und/oder Adhäsionsschichten sind während des Aufbringens der Schicht oder des Schichtstapels selbst nicht verspannt oder modifiziert. Jedoch kann die Schicht oder der Schichtstapel verspannt auf die Opfer- und/oder Adhäsionsschicht aufgebracht werden, so dass sich die Schicht oder der Schichtstapel beim teilweisen oder vollständigen Entfernen der Opferschicht und/oder bei der Modifizierung der Adhäsionsschicht entspannt und seine Form ändert, beispielsweise aufrollt. Es ist aber auch möglich, dass die Schicht oder Schichten auf die Opfer- und/oder Adhäsionsschicht ohne Verspannung aufgebracht werden und sich erst durch das teilweise oder vollständige Entfernen der Opferschicht und/oder bei der Modifizierung der Adhäsionsschicht der Schichtstapel verspannen und dadurch ihre Form ändern und beispielsweise aufrollen.

Im Falle, dass die Schicht oder der Schichtstapel in einem verspannten Zustand, vorteilhafterweise differentiell verspannt, auf das Substrat aufgebracht wird, wird die Verspannung beispielsweise durch teilweise oder vollständige Entfernung der Opfer- und/oder Adhäsionsschicht oder durch Modifizierung der Opfer- und/oder Adhäsionsschicht auf chemische, mechanische, elektrische, thermische, optische, magnetische oder elektromagnetische Art und Weise, gelöst, so dass sich die aufgebrachte Schicht oder Schichten von dem Substrat ablöst und in eine helikale, röhrenförmige (zylindrische), elliptische, hyperbolische, torodiale, wellenförmige und/oder polygonale Form verformt.
Unter der Modifizierung der Opfer- und/oder Adhäsionsschicht auf dem Substrat soll im Rahmen der vorliegenden Erfindung verstanden werden, dass die Modifizierung der Opfer- und/oder Adhäsionsschicht nach einem Auslösen der Modifizierung zur Verformung der nachfolgend aufgebrachten Schicht oder Schichten führt, beispielsweise in eine helikale, röhrenförmige (zylindrische), elliptische, hyperbolische, torodiale, wellenförmige und/oder polygonale Form. Dies kann beispielsweise durch Auslösen chemischer oder physikalischer Prozesse an, in oder um die Opfer- und/oder Adhäsionsschicht, beispielsweise durch Erreichen einer Temperatur, bei der die Opfer- und/oder Adhäsionsschicht schmilzt, oder durch Auslösen einer chemischen oder/und physikalischen Reaktion in der Opfer- und/oder Adhäsionsschicht.

Nach dem Aufbringen der mindestens einen Opfer- und/oder Adhäsionsschicht wird mindestens eine Schicht aus einem Trägermaterial aufgebracht. Diese eine oder mehreren Schichten aus Trägermaterialien können dabei vorteilhafterweise aus Metall, Metallverbindungen, organischen Metallkomplexen, Keramik, halbleitenden Materialien und/oder Polymeren hergestellt werden und bestehen. Die ein oder mehreren Schichten aus Trägermaterialien können verspannt auf die Opfer- und/oder Adhäsionsschicht aufgebracht werden, oder sich nach dem Entfernen und/oder der Modifizierung der Opfer- und/oder Adhäsionsschicht verspannen, so dass sich in jedem Fall ihre Form von der planaren Form in eine dreidimensionale Form ändert.

Als Trägerschicht können auch mehreren Schichten vorhanden sein. Die einzelnen Schichten aus dem Trägermaterial können vollflächig oder auch teilweise vorhanden sein.
Eine oder mehrere Schichten aus Trägermaterialien sind im verspannten Zustand aufgebracht und/oder sie befinden sich in einem Zustand, der beim Lösen einer Verspannung eine Verformung in einen dreidimensionalen Zustand der Schicht oder Schichten aus den Trägermaterialien und der darauf befindlichen Schichten realisiert.

Beispielsweise kann eine Schicht aus einem Trägermaterial eine quellbare Schicht sein, die durch das Auflösen oder Modifizieren der Opfer- und/oder Adhäsionsschicht oder durch Einbringen eines Quellmittels aufquillt und damit alle auf der quellbaren Schicht angeordneten Schichten dreidimensional verformt.

Alle Schichten können mit an sich bekannten Verfahren, wie CVD, PVD, Sputtern, aber auch Spin-Coating, Sprühen, Drucktechnologien (Tintendruck, Flexographie, Gravur usw.) Rakeln, Gießen aufgebracht werden. Die Opfer- und/oder Adhäsionsschichten können auch mittels lithografischer Verfahren aufgebracht und strukturiert werden.
Ebenso können alle Schichten vollflächig auf die darunter vorhandene Schicht oder Substrat aufgebracht werden, oder auch nur teilweise und ebenfalls strukturiert oder unstrukturiert.

Auf die mindestens eine Trägerschicht wird dann mindestens eine Schicht oder mehrere Schichten aus einem Materialsystemen aufgebracht, die zur Herstellung eines oder mehrerer Bauteile zur Messung und/oder Generierung von Vektorfeldern in mindestens einer Richtung dienen.
Auch diese Schicht oder Schichten aus den Materialsystemen können verspannt auf die Trägerschicht, oder im Falle eines nicht vollflächigen Aufbringens der Trägerschicht auch direkt auf die Opfer- und/oder Adhäsionsschicht, aufgebracht werden, oder sie können sich nach dem Entfernen und/oder der Modifizierung der Opfer- und/oder Adhäsionsschicht verspannen, so dass sich in jedem Fall auch ihre Form von der planaren Form in eine dreidimensionale Form ändert.

Es werden eine oder mehrere Schichten aus den Materialsystemen aufgebracht, die vorteilhafterweise zur Herstellung von Kontaktierungen, Hall-, GMR-, TMR-, AMR-, MR-, MI-, GMI-Sensoren, Spinventilen, magnetische Spulen, Antennen, optische Sensoren und/oder Quellen, mechanischen Zug- und/oder Drucksensoren, thermischen Sensoren, akustischen Sensoren, Kondensatoren, Transistoren, Dioden und/oder Widerstände aufgebracht werden. Je nach gewünschtem Bauteil wird die Materialzusammensetzung, Anordnung, Abmessungen, Strukturierungen ausgewählt und auf die Trägerschicht(en) aufgebracht.

Dabei ist erfindungsgemäß von besonderer Bedeutung, dass bei der Anordnung der gewünschten Bauteile auf der Trägerschicht die Position auf der Trägerschicht dahingehend gezielt ausgewählt wird, dass nach der Herstellung des dreidimensionalen Bauelementes das jeweilige Bauteil sich an der dreidimensional gewünschten Position befindet.
Dies ist der besondere Vorteil des erfindungsgemäßen Herstellungsverfahrens, dass die Herstellung der Bauteile mit bekannten und einfachen und kostengünstigen Technologien in planarer Bauweise realisiert werden kann und so mit einem einfachen, technologisch gut beherrschbaren Verfahren sehr komplexe Bauelemente in dreidimensionaler Ausrichtung erreichbar sind.

Bei der Herstellung der Bauteile durch Aufbringung von einer oder mehrerer Schichten auf die Trägerschicht ist mit zu berücksichtigen, dass ebenfalls Schichten aus elektrisch leitfähigem Material für elektrische Kontaktierungen zur Stromversorgung des oder der Bauteile aufgebracht werden. Dies ist jedoch nur bei den Bauteilen erforderlich, die mit elektrischem Strom versorgt werden müssen, wie Sensoren, Kondensatoren usw. Bauteile, wie beispielsweise Magneten, benötigen keine eigene Stromversorgung, so dass dafür keine separaten Kontaktierungen zur Stromversorgung vorhanden sein müssen. Derartige Bauteile, aber auch andere Bauteile auf der oder den Trägerschichten sind und/oder können mit anderen Bauteilen auf der oder den Trägerschichten elektrisch leitend verbunden werden. Schichten für derartige Kontaktierungen müssen erfindungsgemäß ebenfalls aufgebracht werden.
Die elektrischen Kontaktierungen sind vorteilhafterweise Leiterbahnen aus einem mindestens teilweise elektrisch leitfähigem Material, wie Kupfer, Gold, leitfähigen Polymeren, Halbleitern oder Oxiden.

Nachdem alle für die gewünschten Bauteile und ihre Versorgung notwendigen Schichten in planarer Ausrichtung auf der oder den Trägerschichten, oder im Falle eines nicht vollständigen Aufbringens der Trägerschicht auf der Opfer- und/oder Adhäsionsschicht auch teilweise direkt auf die Opfer- und/oder Adhäsionsschicht, aufgebracht worden sind, wird die Opfer- oder Adhäsionsschicht teilweise oder vollständig abgelöst oder modifiziert. Dadurch wird entweder die Verspannung der verspannten und/oder modifizierten Schicht oder Schichten auf der Opfer- und/oder Adhäsionsschicht gelöst, oder die Verspannung der Schicht oder Schichten auf der Opfer- und/oder Adhäsionsschicht ausgelöst. Damit wird in jedem Fall eine Verformung der Schicht oder Schichten in eine dreidimensionale Form erreicht und gleichzeitig ein mindestens teilweises Ablösen der Schicht oder Schichten von der Opfer- und/oder Adhäsionsschicht und/oder dem Substrat. Dieser verformte und damit aus der planaren Ebene herausgeformte dreidimensionale Schichtstapel ist das erfindungsgemäß hergestellte dreidimensionale Bauelement.

Nachfolgend können noch weitere Verfahrensschritte durchgeführt werden, wie beispielsweise die Entfernung des dreidimensionalen Bauelementes vom Substrat und Positionierung an anderer Stelle und/oder auf einem anderen Substrat, beispielweise als Array.

Ebenfalls können mit dem erfindungsgemäßen Verfahren auf einem Substrat gleichzeitig mehrere baugleiche und/oder hinsichtlich ihres Aufbaus und Funktion unterschiedliche Bauelemente hergestellt werden.

Mit dem erfindungsgemäßen Verfahren kann auch das erfindungsgemäß hergestellte Bauelement realisiert werden, bei welchem auf einem dreidimensionalen Träger aus mindestens einem Trägermaterial mindestens zwei Bauteile aus Materialsystemen vorhanden ist, welche in ihrer räumlichen Position auf, an und/oder in dem Träger mindestens ein Vektorfeld in mindestens zwei unterschiedlichen Richtungen misst und/oder generiert.

Dabei ist erfindungsgemäß von besonderer Bedeutung, dass sich die Bauteile in einer räumlich anderen Position auf, an und/oder in dem Träger befinden, als in der Herstellungspos ition.

Als Trägermaterialien können vorteilhafterweise Metalle, Metallverbindungen, organische Metallkomplexe, Keramiken, halbleitende Materialien und/oder Polymere den dreidimensionalen Träger bilden.

Der Träger kann in verschiedenen dreidimensionalen Formen vorliegen, beispielsweise in helikaler, röhrenförmiger (zylindrischen), elliptischer, hyperbolischer, toroidale, wellenförmiger und/oder polygonaler Form.
An jedem räumlichen Punkt des dreidimensionalen Trägers kann sich erfindungsgemäß ein Bauteil befinden, dessen Mess- und/oder Generierungsrichtung im Vektorfeld gleich und/oder unterschiedlich sein können.

Als Bauteile können Kontaktierungen, Hall-, GMR-, TMR-, AMR-, MR-, MI-, GMI-Sensoren, Spin-ventile, magnetische Spulen, Antennen, optische Sensoren und/oder Quellen, mechanische Zug- und/oder Drucksensoren, thermische Sensoren, akustische Sensoren, Kondensatoren, Transistoren, Dioden und/oder Widerstände vorhanden sein.

Bei dem erfindungsgemäß hergestellten Bauelement sind an, auf und/oder in dem Träger mindestens zwei Bauteile vorhanden. Es können auch zwei, drei, 10, 100, 1000 Bauteile oder mehr an, auf und/oder in dem Träger vorhanden sein.
Die Abmessungen der erfindungsgemäß hergestellten Bauelemente liegen vorteilhafterweise im Milli-, Mikro- und/oder Nanometerbereich und der dreidimensionale Träger kann eine Breite von mindestens 0.1 mm und eine Länge von mindestens 0.1 mm Länge und eine Wanddicke von mindestens 10 nm aufweisen.

Mit dem erfindungsgemäß hergestellten Bauelement können Vektorfelder verschiedenster physikalischer Größen gemessen und/oder generiert werden. Dazu müsse die erfindungsgemäß hergestellten Bauelemente je nach Anwendungsbedarf mit den entsprechenden Bauteilen zur Messung und/oder Generierung des gewünschten Vektorfeldes in gewünschter Anzahl und Richtung hergestellt und positioniert werden.
Ebenso vorteilhafterweise werden die erfindungsgemäß hergestellten dreidimensionalen Bauelemente mit jeweils einer übereinstimmenden Richtung des Bauteils auf dem Träger und/oder Substrat angeordnet.
Nach dem Stand der Technik sind zwei- und auch dreidimensionale Bauelemente bekannt, mit denen in einer oder zwei oder drei Richtungen eines Vektorfeldes einzeln oder gleichzeitig gemessen werden kann. Im Falle der Messungen von zwei oder drei Richtungen gleichzeitig, können nur Richtungen gemessen werden, die orthogonal zueinanderstehen. Je Messrichtung muss jeweils ein Messelement vorhanden sein.
Im Gegensatz dazu lassen sich erfindungsgemäß einerseits bei Vorhandensein auch nur zwei oder drei Bauteilen auf, an oder in dem Träger auch drei Raumrichtungen eines Vektorfeldes gleichzeitig messen, jedoch von jedem einzelnen Bauteil auch gleichzeitig oder nacheinander auch noch in weiteren Richtungen, die nicht orthogonal zu den anderen Raumrichtungen stehen.

Das erfindungsgemäß hergestellte Bauelement kann vorteilhafterweise mittels des erfindungsgemäßen Verfahrens hergestellt werden und ist durch seine Variabilität in Anordnung der Bauteile und der Variabilität in Bezug auf die Form und Funktion der Bauteile sehr anpassungsfähig an verschiedene Anwendungen.

Beispielsweise kann die magnetische Flussdichte, auch magnetische Induktion, bisweilen umgangssprachlich einfach nur "Flussdichte" oder "Magnetfeld" genannt, die die Flächendichte des magnetischen Flusses ist, der senkrecht durch ein bestimmtes Flächenelement hindurchtritt, mit dem erfindungsgemäß hergestellten Bauelement gemessen werden. Die magnetische Feldstärke *̅H̅*̅ oder Flussdichte *̅B̅*̅ ist - ebenso wie die elektrische Feldstärke *̅E̅*̅ oder Flussdichte *D̅ -* eine gerichtete Größe, also ein Vektor. (Wikipedia, Stichwort magnetische Flussdichte).

Mit dem vorliegenden erfindungsgemäß hergestellten dreidimensionales Bauelement zur bi-, tri- oder multidirektionalen Messung und/oder Generierung von Vektorfeldern kann insbesondere die Richtung, aber auch die Größe und/oder der Gradienten für unterschiedliche Vektorfelder, beispielsweise magnetische oder elektromagnetische Größen, Druck- und Zugbelastung, mechanische Spannung oder Temperatur gleichzeitig und/oder nacheinander und in eine und/oder mehrere Richtungen und/oder Gradienten gemessen und vorteilhafterweise auch geändert werden.

Mit dem vorliegenden erfindungsgemäß hergestellten dreidimensionalen Bauelement zur bi-, tri- oder multidirektionalen Messung und/oder Generierung von Vektorfeldern können vorteilhafterweise konstante oder dynamische Magnetfelder in Bezug auf Richtung (Vektor) und Größe (Skalar) gemessen werden, wobei die magnetischen Feldgrößen in allen drei Dimensionen zuverlässig und vorteilhafterweise gleichzeitig und bei kleiner Bauform gemessen werden können. Dabei ist erfindungsgemäß die Richtung der magnetischen Flussdichte vorrangig gegenüber ihrer Größe.

Auch können mit dem vorliegenden erfindungsgemäß hergestellten dreidimensionalen Bauelement zur multidirektionalen Messung und/oder Generierung von Vektorfeldern vorteilhafterweise die Temperatur, mechanische Zug- oder Druckbelastung, mechanische Spannung oder die Temperatur gemessen und vorteilhafterweise auch verändert werden.

Ebenso vorteilhafterweise kann mit einem Array, also einer Vielzahl, an erfindungsgemäß hergestellten dreidimensionalen Bauelementen auf einem Substrat die Ortung der Position von Objekten im dreidimensionalen Raum realisiert werden, wie das Imaging von ionischen, magnetischen, metallischen und/oder stromleitenden Objekten.
Weiterhin kann das erfindungsgemäß hergestellte dreidimensionale Bauelement zur Messung der magnetischen Flussdichte, wie beispielsweise in einem elektronischen Kompass oder Verschlüsslern/Encodern oder elektromagnetischer Strahlung in Richtantennen eingesetzt werden.

Vorteilhafterweise ist mit den erfindungsgemäß hergestellten Bauelementen auch die Messung von zwei physikalischen Messgrößen in Abhängigkeit voneinander möglich, beispielsweise die Messung des magnetischen Feldes in Abhängigkeit von der Temperatur.

Sofern das erfindungsgemäß hergestellte Bauelement die Messung auf der Basis des Halleffektes vornimmt, wird die Hallspannung gemessen. Im Falle der Messung auf der Basis des Magnetimpedanzeffektes wird der elektrische Widerstand gemessen.
Der Magnetimpedanzeffekt beschreibt die Änderung des komplexen Widerstandes eines magnetischen Materials beim Anlegen eines magnetischen Feldes. Der Magnetimpedanzeffekt umfasst dabei alle Magnetwiderstandseffekte, wie den Anisotropiemagnetwiderstandseffekt (Anisotropic magnetoresistance AMR), Riesenmagnetwiderstandseffekt (Giant magnetoresistance GMR), den Tunnelmagnetwiderstandseffekt (Tunnel magnetoresistance TMR), den Magnetwiderstand (extraordinary MR), den unregelmäßigen Hall- und MagnetWiderstand (anomalious Hall and MR), und den Riesenmagnetimpedanzeffekt (Giant magnetoimpedance GMI).

Als Vektorfeld kann erfindungsgemäß ein magnetisches, elektrisches, elektromagnetisches, thermisches oder mechanisches Vektorfeld verstanden.

Ein weiterer Unterschied zu den Lösungen des Standes der Technik besteht bei der erfindungsgemäßen Lösung darin, dass mit dem erfindungsgemäß hergestellten Bauelement auch Vektorfelder generiert werden können, sowohl bi-, tri- oder multidirektional als auch nacheinander und/oder gleichzeitig.

Durch gezielte Positionierung und Auswahl der Richtung jedes einzelnen Bauteils beim Aufbringen auf die Trägerschicht, kann gezielt die Position und Richtung des Bauteils nach der Verformung der Trägerschicht im Raum bestimmt und hergestellt werden. Dabei wird auch gezielt die Richtung zum Messen und/oder Generieren in eine bestimmte Raumposition gebracht und verändert.

Neben dem Vorteil der geringen Baugröße der erfindungsgemäß hergestellten Bauelemente bestehen weitere Vorteile der erfindungsgemäßen Lösung in der Flexibilität der Herstellung. Das bekannte Pick-and-place-Verfahren ist zeitaufwändig und wird erfindungsgemäß nicht eingesetzt.

Hinzu kommt, dass die Form der erfindungsgemäß hergestellten Bauelemente dem jeweiligen Einsatz angepasst werden kann. Dadurch können die erfindungsgemäß hergestellten Bauelemente problemlos in bereits vorhandene, bekannte und industriell eingesetzte elektronische Apparate und Maschinen, wie Mobiltelefon, Laptops usw. eingebaut und an die vorhandenen Abmessungen angepasst werden.

Nachfolgend wird die Erfindung an mehreren Ausführungsbeispielen näher erläutert.

### Beispiel 1

Ein Substrat aus Siliciumdioxid mit den Abmessungen 100 x 100 mm² und einer Dicke von 1 mm wird für 5 min in Aceton und Isopropanol getaucht, mit Ultraschall behandelt und anschließend in deionisiertem (DI) Wasser gespült. Nachfolgend wird das Substrat für 30 min in einer 2 %-igen wässrigen Lösung eines Alconoxreinigers (Alconox Inc.) mit Ultraschall behandelt und gründlich mit deionisiertem Wasser bei Ultraschall gespült. Nach der Reinigung wird das Substrat in DI-Wasser belassen, um die Oberfläche vor Verunreinigungen und Hydrolisierung zu schützen.

Auf die Substratoberfläche wird vollflächig eine Monoschicht aus 3-(Trimethoxylyl)-Propylmethacrylat (Polysciences Europe GmbH) als Adhäsionsschicht aufgebracht, indem das Substrat für 20 min mit in eine 1,5-Vol-%-Mischung von Silan in Toluen (Sigma-Adrich Co. LLC, Deutschland) eingetaucht und so die hergestellte Adhäsionsschicht hergestellt und modifiziert wurde. Nachfolgend wird das beschichtete Substrat in Toluen gewaschen, mit Stickstoffgas getrocknet und auf einer heißen Platte bei 120 °C für 20 min bei Stickstoffatmosphäre getrocknet.

Auf diese Adhäsionsschicht wird vollflächig als Opferschicht eine strukturierte Schicht in rechteckiger Form aus Acrylsäure (AA)(Alfa Aesar) und hydriertem LaCl₃ (Alfa Aesar) aufgebracht. Dazu wird eine Mischung von 10 g AA mit 4,86 g LaCl₃ in Wasser hergestellt, die zu einem Niederschlag von LaAA bei einem erhöhten pH-Wert der Lösung von 10 führt. Dieser Niederschlag wird durch Filterpapier in einem Exicator gesammelt, wo dieser Niederschlag bei 40 °C für 10 Stunden getrocknet wird. Weiter wird das erhaltene Material in AA gelöst und bei einer Konzentration von 25 Gew.-% mit 2 Gew.-% 2-Benzyl-2-(dimethylamino)-4-morpholinobutyrophenon und 3 Gew.-% Methyldiethynolamin (Sigma-Adrich Co. LLC., Deutschland) photosensibilisiert. Diese Opferschichtlösung wird mittels Spin-Coating bei 3000 U/min für 35 s eine 160 nm-dicken Schicht hergestellt. Die Trocknung wird bei 35 °C für 2 min durchgeführt und anschließend erfolgt die Strukturierung durch eine Behandlung mit einer 405 nm Quecksilber h-Linie (20 mW/cm²) für 15 s durch eine Glass/Cr-Blende durch Einsatz einer SUSS MA4 (Karl Suss KG - GmbH & Co, München-Garching, Deutschland) Blenden-Justiervorrichtung. Die Entwicklung erfolgt in DI-Wasser für 5 s mit nachfolgendem Spülen in (1-Methoxy-2-Propyl)-Acetat (Sigma-Aldrich Co. LLC., Deutschland). Schließlich werden die Proben bei 200 °C für 5 min bei Stickstoff-Atmosphäre getempert, um alle Lösungsmittelreste zu entfernen.

Auf die Adhäsionsschicht wird eine mehrschichtige Trägerschicht aufgebracht. Zuerst wird eine rechteckige polymere Quellschicht vollflächig auf die Opferschicht aufgebracht, die aus einer Reaktion von N-(2-Hydroxyehtyl) acrylamid (HEAA) und Poly(ethylen-alt-maleic-Anhydrid) (PEMA) in N,N-Dimthylacetamid (DMAc) hergestellt wird, wobei das DMAc durch eine 2 Gew.-% 2-Benzyl-2-(dimethylamino)-4-morpholinobutyrophenon (Sigma-Adrich Co. LLC., Deutschland). 6 g PEMA wird in 50 ml DMAc gelöst und 5,75 g HEAA hinzugegeben. Die Reaktion erfolgt für 10 h bei Raumtemperatur. Die Lösung wird beim 4000 -8000 U/min mittels Spin-Coating auf die Opferschicht aufgeschleudert, die Dicke der daraus resultierenden Quellschicht beträgt 1000 - 300 nm. Nach der Trocknung der polymeren Quellschicht bei 50 °C für 5 min wird der Schichtstapel auf dem Substrat für 1,5 min 405 nm Quecksilber h-Linie (20 mW/cm²) durch eine Glass/Cr Blende durch Einsatz einer SUSS MA4 (Karl Suss KG - GmbH & Co, München-Garching, Deutschland) einer Blenden-Justiervorrichtung ausgesetzt. Die Entwicklung der Mischung wir in einem Volumenteil DMAc und 2 Volumenteilen Propylencarbonat (Sigma-Aldrich Co. LLC., Deutschland) für 30 s durchgeführt mit nachfolgendem Spülen in Isopropanol. Schließlich wird der Schichtstapel auf dem Substrat bei 200 °C für 5 min in Stickstoff-Atmosphäre getempert, um überschüssige Lösungsmittel zu entfernen.

Die differentielle Spannung wird in der Quellschicht (Hydrogel) durch Quellen in einem wässrigen Medium erreicht. Das Quellen der Quellschicht wird realisiert, wenn der gesamte Schichtstapel aufgebracht ist. Während des Quellens wird die Opferschicht vollständig entfernt. Die Adhäsionsschicht verbleibt im unveränderten Zustand.

Als zweite Schicht aus Trägermaterial wird eine Polyimid-Schicht auf die Quellschicht aufgebracht. Das photosensitive Polyimid wird durch die Reaktion von 3,3',4,4'-Benzphenontetracarboxyl-Dianhydrid (BPDA) und 3,3'-Diaminodiphenyl Sulfone (DADPS) in N,N-Dimethylacetamid (DMAc) hergestellt, mit DimethylaminoethylMethacrylat (DMAEMA) und mit 2 Gew.-% 2-Benzyl-2-(dimethylamino)-4-morpholinobutyrophenon (Sigma-Aldrich Co. LLC., Deutschland) photosensiviert. Die Polyimidsynthese wurde durch Lösung von 9,93 g DADPS in 20 ml DMAc mit einem nachfolgenden Hinzufügen von 12,8 g BPDA durchgeführt. Nachdem die Mischung für 12 h bei 70 °C gerührt wurde, wurde die Lösung von Polyamidsäure (PAA) in DMAc erreicht. Die Lösung von PAA wird durch Reaktion mit 12,5 g DMAEMA neutralisiert. Das Polyimid wurde mittels Spin-Coating bei 2000 - 8000 U/min für 35 s als zweite Trägerschicht vollflächig in rechteckiger Form auf die Quellschicht aufgeschleudert. Es entsteht eine Polyimidschicht mit einer Dicke von 1700 - 500 nm. Nach Trocknung der Polyimidschicht bei 50 °C für 3 min wird die Probe für 1,5 min 405 nm Quecksilber h-Linie (20 mW/cm²) durch eine Glass/Cr Blende durch Einsatz einer SUSS MA4 (Karl Suss KG - GmbH & Co, München-Garching, Deutschland) einer Blenden- Justiervorrichtung zur Strukturierung ausgesetzt. Die Entwicklung erfolgt in einer Mischung von einem Volumenteil 1-Ethyl-2-Pyrrolidon, 0,58 Volumenteile Methylalkohol und 0,5 Volumenteile Diethylenglycolmonoethylether für 1 min mit nachfolgendem Spülen in Propylenglycolmonomethyletheracetat (Sigma-Aldrich Co. LLC., Deutschland).
Die Trocknung der Polyimidschicht wird durchgeführt, indem auf einer Heizplatte bei 200 °C für 5 min unter Stickstoffatmosphäre gleichzeitig die überschüssigen Lösungsmittel entfernt werden.

Im Anschluss wird ein strukturierter Schichtstapel zur Herstellung von 6 Sensoren aus magnetischen Materialien, bestehend aus Ta(2 nm)/Py(4 nm)/CoFe(1 nm)/Cu(1,8 nm)/CoFe(1 nm)/Py(4 nm)/lrMn(5 nm)/Ta(2 n m), mittels Magnetron-Sputter-Abscheidung in einer Hochvakuumkammer (Basisdruck: 4x10⁻⁷ mbar; Ar-Sputter-Druck: 6x10⁻⁴ bar; Abscheidungsrate: 0,2Å/s) in Gegenwart eines homogenen Magnetfeldes von 40 mT zur Erzeugung der magnetischen Anisotropie auf die Polyimidschicht aufgebracht und durch die Anordnung auf der Polyimidschicht in eine parallele Richtung zum Feld und im 45°-Winkel zur Self-assembly-Richtung ausgerichtet. Der Schichtstapel wird dann mit einer 2-nm-dicken Ta-Schicht vollständig bedeckt, um die Adhäsion zu verbessern und den magnetischen Stapel während des Lithographieprozesses zu schützen.

Die elektrischen Kontakte werden mit Cr(5 nm)/Au(50 nm)-Zweifachschicht über Elektronenstrahlverdampfung (Basisdruck: 1x10⁻⁶ mbar; Abscheidungsrate: 2 Å/s) zu allen Sensoren gleichzeitig hergestellt. Die Breite der Kontakte beträgt 40 µm. Die Kontaktierungen und Sensor-Bauteile werden mittels UV-Lithographie-Lifting-off-Verfahren durch Abheben von der darunter liegenden photoresistiven Schicht strukturiert.

In einem einzigen Herstellungsprozess kann ein Array an Bauelementen über das gesamte Substrat von 100x100 mm² mit einer Anzahl von 400 Bauelementen pro Probe hergestellt werden.

Danach wird der selbst-zusammenbauende (self-assembly)-Prozess des Bauelementes zu einer röhrenförmige Struktur durchgeführt.
Dazu wird durch selektives Ätzen der Opferschicht und Quellen der Quellschicht in einer Lösung von 0,5 M Natriumdiethylenetriaminpentaacetat (DTPA) (Alfa Aesar, UK) das bisherige planare 2D-Layout in eine 3D-Schweizer Rolle mit Positionierung der sechs magnetischen Sensoren um die Achse der Helix aufgerollt (self-assembly). Die ursprüngliche Orientierung der Sensoren von 45° in Bezug auf die Zusammenbau-Achse (Aufrollachse) wird in der 3D-Geometrie beibehalten. Die relative Orientierung der magnetischen Sensor-Bauteile verändert sich durch das Aufrollen so, dass die Messrichtung der Sensor-Bauteile in einem Winkel von je 30°, 45° und 120° zueinander ausgerichtet sind.
Auf diese Weise wurde ein 3-dimensionales magnetisches Bauelement erhalten, welches das magnetische Feld einer externen dynamischen und statischen Quelle eines magnetischen Feldes, wie beispielsweise eines implantierten Magneten, oder von elektrischen oder ionischen Ströme im tierischen oder menschlichen Körper, misst.

Nach dem Ätzprozess werden die Strukturen in DI-Wasser gewaschen und anschließend in eine Lösung von DI-Wasser und Isopropanol im Verhältnis 1:5 für 10 min gegeben und schließlich bei Umgebungsbedingungen getrocknet.

Mit dem so hergestellten dreidimensionalen Bauelement kann die Messung der Position und der Orientierung von beispielsweise Implantaten in Herzklappen oder auf der Herzoberfläche in mehreren Richtungen und auch gleichzeitig erfolgen. Das einzelne Bauelement hat einen geringen Raumbedarf und kann die von einem vergleichbaren Bauelement nach dem Stand der Technik bisher belegte Fläche mit mehreren erfindungsgemäß hergestellten Bauelementen gleichzeitig bedecken. Damit können mehr und andere Messungen gleichzeitig durchgeführt werden.
Die Herstellung des dreidimensionalen Bauelementes ist einfach und kostengünstig.

### Beispiel 2

Gemäß Beispiel 1 werden auf einem Substrat eine Opferschicht, eine Adhäsionsschicht, eine Quellschicht und zweite Trägerschicht abgeordnet.

Dabei wird die Quellschicht in 9 Streifen und die zweite Trägerschicht aus Polyimid so angeordnet, dass nach dem quellen der Quellschicht und dem teilweisen Ablösen der Opferschicht sich drei dreieckige Flächen von dem Substrat ablösen und mit der vierten dreieckigen Schicht, die auf der Substratebene verbleibt, ein dreidimensionales Bauelement in Tetraederform bilden.

Nach dem Aufbringen der Polyimidschicht wird mittig auf je eine Tetraederfläche eine strukturierte Schicht aus Bismut mit einer Dicke von 50 nm in Form eines Kreuzes zur Herstellung je eines Hall-Sensors mittels Magnetron-Sputter-Abscheidung in einer Hochvakuumkammer (Basisdruck: 4x10⁻⁷ mbar; Ar-Sputter-Druck: 6x10⁻⁴ bar; Abscheidungsrate: 0,2 Å/s) auf die Polyimidschicht aufgebracht.

Danach wird der selbst-zusammenbauende (self-assembly)-Prozess des Bauelementes zu einer tetraedrischen Struktur durchgeführt.
Die ursprüngliche Orientierung der Kondensatoren in Bezug auf die Zusammenbau-Achse wird in der 3D-Geometrie beibehalten. Die relative Orientierung der Halleffekt-Sensoren verändert sich durch die dreidimensionale Form, so dass die Messrichtung der Sensoren in einem Winkel von ~70° zueinander ausgerichtet sind.

Auf diese Weise wurde ein 3-dimensionales Bauelement erhalten, welches das magnetische Feld eines externen Magneten in einer mechanischen Verbindung einer mechanischen Prothese misst.
Nach dem Ätzprozess werden die Strukturen in DI-Wasser gewaschen und anschließend in eine Lösung von DI-Wasser und Isopropanol im Verhältnis 1:5 für 10 min gegeben und schließlich bei Umgebungsbedingungen getrocknet.

Mit dem so hergestellten dreidimensionalen Bauelement kann die Messung der Position und der Orientierung der Fingerglieder einer mechanischen Prothese in mehreren Richtungen und gleichzeitig erfolgen Das einzelne Bauelement hat einen geringen Raumbedarf und kann die von einem vergleichbaren Bauelement nach dem Stand der Technik bisher belegte Fläche mit mehreren erfindungsgemäß hergestellten Bauelementen gleichzeitig bedecken. Damit können mehr und andere Messungen gleichzeitig durchgeführt werden.
Die Herstellung des dreidimensionalen Bauelementes ist einfach und kostengünstig.

### Beispiel 3

Gemäß Beispiel 1 werden auf einem Substrat eine Opferschicht und darauf eine Quellschicht in Form eines Hydrogels und darauf eine zweite Trägerschicht aus Polyimid aufgebracht. Nachfolgend werden Schichten zur Herstellung von sechs magnetischen Spulen aus Cr 10 nm/Cu 1000 nm/Cr 10 nm mittels Magnetron-Sputter-Abscheidung in einer Hochvakuumkammer (Basisdruck: 4x10⁻⁷ mbar; Ar-Sputter-Druck: 6x10⁻⁴ bar; Abscheidungsrate: 0,2 Å/s) aufgebracht.

Die elektrischen Kontakte werden mit Cr 10 nm/Cu 1000 nm/Cr 10 nm über Magnetron-Sputter-Abscheidung in einer Hochvakuumkammer (Basisdruck: 4x10⁻⁷ mbar; Ar-Sputter-Druck: 6x10⁻⁴ bar; Abscheidungsrate: 0,2 Å/s) hergestellt. Die Breite der Kontakte beträgt 40 µm. Jede funktionale Schicht inklusive der Kontaktierungen und Bauteile wird mittels UV-Lithographie-Lifting-off-Verfahren durch Abheben von der darunter liegenden photoresistiven Schicht strukturiert.

Danach wird der selbst-zusammenbauende(self-assembly)-Prozess des Bauelementes zu einer röhrenförmigen, zylindrischen Struktur durchgeführt.
Dazu wird durch selektives Ätzen der Opferschicht und Quellen der Quellschicht in einer Lösung von 0,5 M Natriumdiethylenetriaminpentaacetat (DTPA) (Alfa Aesar, UK) das bisherige planare 2D-Layout in einen 3D-Zylinder realisiert mit Positionierung der magnetischen Spulen auf die Mantelfläche des Zylinders (self-assembly). Die relative Orientierung der sechs Spulen in der ursprünglichen 2D-Position verändert sich durch das Aufrollen so, dass die Generierungsrichtung von vier Spulen in einem Winkel von 90° zueinander ausgerichtet ist und die Generierungsrichtung der anderen beiden Spulen in einem Winkel von 90 ° zu den ersten vier Spulen.

Mit dem so hergestellten dreidimensionalen Bauelement wird ein konstantes magnetisches Feld mit einem definierten Gradienten in einem Mikrofluidsystem in allen Raumrichtungen generiert.
Das einzelne Bauelement hat einen geringen Raumbedarf und kann in einem Mikrofluidkanaleines Mikrotomographen (MRI) zur Generierung von Gradienten eines magnetischen Feldes eingesetzt werden.
Die Herstellung des dreidimensionalen Bauelementes ist einfach und kostengünstig.

## Patentansprüche

1. Verfahren zur Herstellung mindestens eines dreidimensionalen Bauelementes zur bi-, tri oder multidirektionalen Messung und/oder Generierung von Vektorfeldern, bei dem
- auf einem Substrat
- mindestens eine Opfer- und/oder Adhäsionsschicht und,
- darauf mindestens eine Schicht aus einem Trägermaterial für einen Träger in einer helikalen, röhrenförmigen, elliptischen, hyperbolischen, toroidalen, wellenförmigen oder polygonalen Form aufgebracht werden,
- und darauf ganz oder teilweise mindestens eine oder mehrere Schichten aus Materialsystemen für mindestens zwei Bauteile zur Messung und/oder Generierung von Vektorfeldern in mindestens zwei unterschiedlichen Richtungen, sowie Schichten aus elektrisch leitfähigem Material für elektrische Kontaktierungen der Bauteile aufgebracht werden,
- wobei die einzelnen Schichten ganz oder teilweise vollflächig aufgebracht werden, und
- wobei die Anordnung der einen oder mehreren Schichten aus Materialsystemen für die Bauteile auf der Trägerschicht an der Position auf der Trägerschicht dahingehend gezielt ausgewählt wird, dass nach der Herstellung des dreidimensionalen Bauelementes das jeweilige Bauteil sich an der dreidimensional gewünschten Position befindet, und
- nachfolgend die Opfer- und/oder Adhäsionsschicht mindestens teilweise von dem Substrat entfernt oder zur Ablösung von dem Substrat modifiziert werden, und durch das Entfernen oder Auslösen der Modifizierung der Opfer- und/oder Adhäsionsschicht die Verformung aller aufgebrachten Schichten in einem einzigen Herstellungsprozess durchführt wird, und
- weitere Verfahrensschritte durchgeführt werden können.

2. Verfahren nach Anspruch 1, bei dem die Schichten mittels lithografischer- oder/und Druckverfahren aufgebracht werden.

3. Verfahren nach Anspruch 1, bei dem mindestens mehrere Schichten aus Materialsystemen für mindestens zwei oder mehrere Bauteile zur Messung und/oder Generierung von Vektorfeldern in mindestens zwei oder drei oder mehr Richtungen, sowie Schichten aus elektrisch leitfähigem Material für elektrische Kontaktierungen der Bauteile aufgebracht.

4. Verfahren nach Anspruch 1, bei dem ein Substrat aus halbleitenden Materialien, Glas, Metall, Metallverbindungen, organischen Metallkomplexen, Si, Si-Wafern, Polymeren oder flexible und/oder dehnbare Materialien eingesetzt wird.

5. Verfahren nach Anspruch 1, bei dem eine Opferschicht und/oder Adhäsionsschicht aus Metall, Metallverbindungen, organische Metallkomplexe, Keramik, halbleitende Materialien und/oder Polymer eingesetzt wird.

6. Verfahren nach Anspruch 1, bei dem ein Trägermaterial aus Metall, Metallverbindungen, organische Metallkomplexe, Keramik, halbleitende Materialien und/oder Polymer eingesetzt wird, wobei mehrere Schichten aus Trägermaterial eingesetzt werden können, wobei vorteilhafterweise eine Schicht aus einer quellbaren Schicht bestehen kann, die ganz oder teilweise auf der Opfer- und/oder Adhäsionsschicht positioniert sein kann, und wobei aus der oder den Schichten aus dem Trägermaterial ein dreidimensionaler Träger in einer helikalen, röhrenförmigen, elliptischen, hyperbolischen, torodialen, wellenförmigen oder polygonalen Form hergestellt werden kann, der mit den weiteren darauf aufgebrachten und verformten Schichten aus Materialsystemen für die mindestens zwei Bauteile das dreidimensionale Bauelement bildet.

7. Verfahren nach Anspruch 1, bei dem Schichten aus Materialsystemen für Kontaktierungen, Hall-, GMR-, TMR-, AMR-, MR-, MI-, GMI-Sensoren, Spinventile, magnetische Spulen, Antennen, optische Sensoren und/oder Quellen, mechanische Zug- und/oder Drucksensoren, thermische Sensoren, akustische Sensoren, Kondensatoren, Transistoren, Dioden und/oder Widerstände als Bauteile aufgebracht werden.

## Claims

1. Method for producing at least one three-dimensional component for the bi-, tri- or multi-directional measurement and/or generation of vector fields, wherein
- on a substrate
- at least one sacrificial and/or adhesion layer and
- thereon at least one layer composed of a carrier material for a carrier in a helical, tubular, elliptical, hyperbolic, toroidal, wavy or polygonal shape are applied,
- and thereon wholly or partly at least one or more layers composed of material systems for at least two component parts for the measurement and/or generation of vector fields in at least two different directions, and layers composed of electrically conductive material for electrical contacts of the component parts are applied,
- wherein the individual layers are applied wholly or partly over the entire surface area, and
- wherein the arrangement of the one or more layers composed of material systems for the component parts on the carrier layer at the position on the carrier layer is selected in a targeted manner to the effect that after the production of the three-dimensional component, the respective component part is situated at the three-dimensionally desired position, and
- afterwards the sacrificial and/or adhesion layer is at least partly removed from the substrate or modified for detachment from the substrate, and by means of the removal or initiation of the modification of the sacrificial and/or adhesion layer, the deformation of all applied layers is carried out in a single production process, and
- further method steps can be carried out.

2. Method according to Claim 1, wherein the layers are applied by means of lithographic or/and printing methods.

3. Method according to Claim 1, wherein at least a plurality of layers composed of material systems for at least two or more component parts for the measurement and/or generation of vector fields in at least two or three or more directions, and layers composed of electrically conductive material for electrical contacts of the component parts are applied.

4. Method according to Claim 1, wherein use is made of a substrate composed of semiconducting materials, glass, metal, metal compounds, organic metal complexes, Si, Si wafers, polymers or flexible and/or stretchable materials.

5. Method according to Claim 1, wherein use is made of a sacrificial layer and/or adhesion layer composed of metal, metal compounds, organic metal complexes, ceramic, semiconducting materials and/or polymers.

6. Method according to Claim 1, wherein use is made of a carrier material composed of metal, metal compounds, organic metal complexes, ceramic, semiconducting materials and/or polymers, wherein a plurality of layers composed of carrier material can be used, wherein a layer can advantageously consist of a swellable layer that can be positioned wholly or partly on the sacrificial and/or adhesion layer, and wherein a three-dimensional carrier in a helical, tubular, elliptical, hyperbolic, toroidal, wavy or polygonal shape can be produced from the layer(s) composed of the carrier material, which carrier together with the further layers composed of material systems for the at least two component parts, said further layers being applied on said carrier and deformed, form the three-dimensional component.

7. Method according to Claim 1, wherein layers composed of material systems for contacts, Hall sensors, GMR sensors, TMR sensors, AMR sensors, MR sensors, MI sensors, GMI sensors, spin valves, magnetic coils, antennas, optical sensors and/or sources, mechanical tension and/or pressure sensors, thermal sensors, acoustic sensors, capacitors, transistors, diodes and/or resistors as component parts are applied.

## Revendications

1. Procédé de fabrication d'au moins un composant tridimensionnel destiné à la mesure bidirectionnelle, tridirectionnelle ou multidirectionnelle et/ou à la génération de champs de vecteurs, procédé dans lequel on applique
- sur un substrat
- au moins une couche sacrificielle et/ou adhésive et,
- sur celle-ci au moins une couche d'un matériau support destiné à un support de forme hélicoïdale, tubulaire, elliptique, hyperbolique, toroïdale, ondulée ou polygonale,
- et entièrement ou partiellement sur celle-ci au moins une ou plusieurs couches de systèmes de matériaux destinées à au moins deux composants de mesure et/ou de génération de champs de vecteurs dans au moins deux directions différentes, ainsi que des couches de matériau électriquement conducteur destinées à la mise en contact électrique des composants,
- les couches individuelles étant appliquées entièrement ou partiellement sur toute la surface, et
- l'agencement de l'une ou de plusieurs couches de systèmes de matériaux destinés aux composants sur la couche de support à la position sur la couche de support étant spécifiquement choisi de telle sorte que, après la fabrication du composant tridimensionnel, le composant respectif se trouve à la position tridimensionnelle souhaitée, et
- ensuite la couche sacrificielle et/ou adhésive étant au moins partiellement retirée du substrat ou modifiée pour se détacher du substrat, et la déformation de toutes les couches appliquées étant réalisée en un seul processus de fabrication par retrait, ou déclenchement de la modification, de la couche sacrificielle et/ou adhésive, et
- d'autres étapes de procédé pouvant être effectuées.

2. Procédé selon la revendication 1, dans lequel les couches sont appliquées à l'aide de procédés lithographiques et/ou d'impression.

3. Procédé selon la revendication 1, dans lequel l'on applique au moins plusieurs couches de systèmes de matériaux destinées à au moins deux ou plusieurs composants de mesure et/ou de génération de champs de vecteurs dans au moins deux ou trois directions ou plus, et des couches de matériau électriquement conducteur destinées aux contacts électriques des composants.

4. Procédé selon la revendication 1, dans lequel on utilise un substrat de matériaux semi-conducteurs, de verre, de métal, de composés métalliques, de complexes organométalliques, de Si, de plaquettes de Si, de polymères ou de matériaux souples et/ou étirables.

5. Procédé selon la revendication 1, dans lequel on utilise une couche sacrificielle et/ou une couche adhésive de métal, de composés métalliques, de complexes organométalliques, de céramique, de matériaux semi-conducteurs et/ou de polymères.

6. Procédé selon la revendication 1, dans lequel on utilise un matériau de support de métal, de composés métalliques, de complexes organométalliques, de céramique, de matériaux semi-conducteurs et/ou de polymère, plusieurs couches de matériau de support pouvant être utilisées, avantageusement une couche pouvant être constituée d'une couche gonflable qui peut être positionnée entièrement ou partiellement sur la couche sacrificielle et/ou adhésive, et un support tridimensionnel de forme hélicoïdale, tubulaire, elliptique, hyperbolique, toroïdale, ondulée ou polygonale pouvant être fabriqué à partir de la couche ou des couches de matériau de support et formant le composant tridimensionnel avec les autres couches, appliquées dessus et déformées, de systèmes de matériaux destinées aux au moins deux composants.

7. Procédé selon la revendication 1, dans lequel des couches de systèmes de matériaux destinées à la mise en contact de capteurs Hall, GMR, TMR, AMR, MR, MI, GMI, de valves à spin, de bobines magnétiques, d'antennes, de capteurs et/ou sources optiques, de capteurs de traction et/ou de compression mécaniques, de capteurs thermiques, de capteurs acoustiques, de condensateurs, de transistors, de diodes et/ou de résistances sont appliquées comme composants.
